# EUROPEAN PATENT SPECIFICATION

(11) **EP 4 401 140 B1**
(45) Date of publication and mention of the grant of the patent: **27.08.2025**
(21) Application number: 24150575.9
(22) Date of filing: 05.01.2024
(51) Int. Cl.: H10K 59/131, G09G 3/3233, G09G 3/20, G09G 3/3258, H10D 86/60, H10D 86/40

(54) **DISPLAY DEVICE**
ANZEIGEVORRICHTUNG
DISPOSITIF D'AFFICHAGE

(30) Priority: 10.01.2023 KR 20230003688
(43) Date of publication of application: 17.07.2024
(73) Proprietor: Samsung Display Co., Ltd., Yongin-si, Gyeonggi-do 17113 (KR)
(72) Inventor: JO, Eunbyul, 17113 Yongin-si (KR); CHO, Youngjin, 17113 Yongin-si (KR)
(74) Representative: Walaski, Jan Filip

(56) References cited:
- CN-A- 110 890 383
- CN-A- 113 764 478
- US-A1- 2022 157 917

## Description

### BACKGROUND

### 1. Field

The present disclosure relates to a display device and a manufacturing method thereof.

### 2. Description of the Related Art

Multimedia display devices such as a TV, a mobile phone, a tablet, a personal computer (PC), a navigation system, a game console, and the like may include a display panel that displays images. The display panel may include a plurality of pixels generating images and a plurality of signal lines connected to the pixels. Meanwhile, as the degree of integration of elements included in the display panel increases and the number of signal lines increases, the area of a region where the signal lines are located may increase. Research into reducing the area of a region where signal lines are located is required to provide users with a display device having a relatively large display area compared to the size of the display device. CN 110890383 A discloses a display device as known from the prior art.

The above information disclosed in this Background section is only for enhancement of understanding of the background and therefore the information discussed in this Background section does not necessarily constitute prior art.

### SUMMARY

Aspects of some embodiments of the present disclosure described herein relate to a display device and a manufacturing method thereof, and for example, to a display device including a line connected to a voltage measurement pad.

Aspects of some embodiments of the present disclosure include a display device with relatively improved reliability of voltage measurement by reducing the area of a non-display area and reducing the resistance of a connection line connected to a voltage measurement pad.

According to some embodiments, a display device includes a base substrate including a display area in which a plurality of pixels are located and a non-display area, a plurality of insulating layers on the base substrate, a pad part including a first voltage pad in the non-display area to receive a first power voltage, a second voltage pad that receives a second power voltage different from the first power voltage, and a voltage measurement pad, a plurality of first lines electrically connected to the plurality of pixels, overlapping the display area, extending in a first direction, and electrically connected to the first voltage pad, a plurality of second lines overlapping the display area and extending in the first direction, a first transfer line electrically connected to each of the plurality of first lines and extending in a second direction crossing the first direction, and a second transfer line extending in the second direction and overlapping the non-display area. The display area is between the first transfer line and the first voltage pad, the display area is between the second transfer line and the second voltage pad, the plurality of second lines include at least one 2-1-th line and at least one 2-2-th line, the 2-1-th line is electrically connected to the voltage measurement pad and electrically connected to the first transfer line, and the 2-2-th line is electrically connected to the second voltage pad and electrically connected to the second transfer line.

According to some embodiments, each of the plurality of pixels may include a pixel circuit on the base substrate and including a transistor, and a light emitting element electrically connected to the pixel circuit, and the plurality of insulating layers may include an organic insulating layer covering the plurality of first lines, the plurality of second lines, and the pixel circuit, and the light emitting element is on the organic insulating layer.

According to some embodiments, the transistor may include a silicon transistor including a silicon semiconductor pattern and a first gate overlapping the silicon semiconductor pattern, and an oxide transistor including an oxide semiconductor pattern and a second gate overlapping the oxide semiconductor pattern. According to some embodiments, the pixel circuit may include a first connection electrode electrically connected to the silicon semiconductor pattern of the silicon transistor, and a second connection electrode connected to the first connection electrode. According to some embodiments, the plurality of insulating layers may include a first insulating layer between the silicon semiconductor pattern and the first gate, a second insulating layer covering the first gate and between the first gate and the oxide semiconductor pattern, a third insulating layer covering the second gate, a fourth insulating layer covering the first connection electrode, and a fifth insulating layer covering the second connection electrode.

According to some embodiments, the light emitting element may include a first electrode on an uppermost insulating layer among the plurality of insulating layers, an emission layer on the first electrode to emit light, and a second electrode on the emission layer to cover the emission layer. According to some embodiments, the plurality of first lines may be electrically connected to the first electrode, and the 2-2-th line of the plurality of second lines may be electrically connected to the second electrode.

According to some embodiments, each of the plurality of second lines may include the same material as the second connection electrode.

According to some embodiments, the display device may further include a third transfer line connected to the plurality of first lines, extending in the second direction, and between the first voltage pad and the display area, and a fourth transfer line connected to the plurality of second lines, extending in the second direction, and between the second voltage pad and the display area.

According to some embodiments, the plurality of first lines and the plurality of second lines may be on the fourth insulating layer and covered by the fifth insulating layer.

According to some embodiments, the first transfer line and the second transfer line may be on the third insulating layer and covered by the fourth insulating layer.

According to some embodiments, the third transfer line and the fourth transfer line may be on the third insulating layer and covered by the fourth insulating layer.

According to some embodiments, the display device may further include a first voltage transfer line connected to a portion of the plurality of first lines, extending in the second direction, and between the third transfer line and the first voltage pad, and a second voltage transfer line connected to a portion of the plurality of second lines, extending in the second direction, and between the fourth transfer line and the second voltage pad.

According to some embodiments, the first voltage transfer line may include a 1-1-th voltage transfer line on the third insulating layer and covered by the fourth insulating layer and a 1-2-th voltage transfer line on the fourth insulating layer and covered by the fifth insulating layer and the 1-1-th voltage transfer line and the 1-2-th voltage transfer line are connected by a contact hole passing through the fourth insulating layer.

According to some embodiments, the first transfer line and each of the plurality of first lines may be on different layers of the plurality of insulating layers and connected through a contact hole defined in an insulating layer between the first transfer line and the plurality of first lines among the plurality of insulating layers.

According to some embodiments, the minimum distances spaced apart from each other of the plurality of second lines are the same.

According to some embodiments, the first transfer line and the second transfer line may be on the same insulating layer among the plurality of insulating layers.

According to some embodiments, the plurality of first lines and the plurality of second lines may be made of aluminum (AL) and titanium (Ti).

According to some embodiments, a display device includes a base substrate including a display area in which a plurality of pixels are and a non-display area, a plurality of insulating layers on the base substrate, a pad part including a first voltage pad in the non-display area to receive a first power voltage, a second voltage pad configured to receive a second power voltage different from the first power voltage, and a voltage measurement pad, a plurality of first lines electrically connected to the plurality of pixels, overlapping the display area, extending in a first direction, and electrically connected to the first voltage pad, a plurality of second lines overlapping the display area and extending in the first direction, a first transfer line electrically connected to each of the plurality of first lines and extending in a second direction crossing the first direction, a second transfer line electrically connected to each of the plurality of second lines and extending in the second direction, and a connection line overlapping the display area and extending in the first direction, wherein the display area is between the first transfer line and the first voltage pad, the display area is between the second transfer line and the second voltage pad, one end of the connection line is electrically connected to the voltage measurement pad and the other end is electrically connected to the first transfer line, and the connection line and the second lines are on the same insulating layer among the plurality of insulating layers.

According to some embodiments, a minimum distance spaced apart from each other of the plurality of second lines may be equal to a minimum distance between the connection line and the second line closest to the connection line among the plurality of second lines.

According to some embodiments, each of the plurality of pixels may include a pixel circuit on the base substrate and including a transistor, and a light emitting element electrically connected to the pixel circuit, and the plurality of insulating layers may include an organic insulating layer covering the plurality of first lines, the plurality of second lines, and the pixel circuit, and the light emitting element is on the organic insulating layer.

According to some embodiments, the transistor may include a silicon transistor including a silicon semiconductor pattern and a first gate overlapping the silicon semiconductor pattern, and an oxide transistor including an oxide semiconductor pattern and a second gate overlapping the oxide semiconductor pattern. According to some embodiments, the pixel circuit may include a first connection electrode electrically connected to the silicon semiconductor pattern of the silicon transistor, and a second connection electrode connected to the first connection electrode. According to some embodiments, the plurality of insulating layers may include a first insulating layer overlapping between the silicon semiconductor pattern and the first gate, a second insulating layer covering the first gate and between the first gate and the oxide semiconductor pattern, a third insulating layer covering the second gate, a fourth insulating layer covering the first connection electrode, and a fifth insulating layer covering the second connection electrode. According to some embodiments, the connection line and the plurality of second lines may be on the fourth insulating layer and covered by the fifth insulating layer.

According to some embodiments, the first transfer line and the second transfer line may be on the third insulating layer and covered by the fourth insulating layer.

### BRIEF DESCRIPTION OF THE DRAWINGS

The above and other characteristics and features of embodiments according to the present disclosure will become more apparent by describing in more detail aspects of some embodiments thereof with reference to the accompanying drawings.
FIG. 1 is a perspective view illustrating a display device.
FIG. 2 is an exploded perspective view of a display device.
FIG. 3 is a cross-sectional view of a display module.
FIG. 4 is a plan view of a display panel.
FIG. 5 is a cross-sectional view of a display device.
FIG. 6 is a cross-sectional view of a display device taken along the line I-I' of FIG. 4.
FIG. 7 is an enlarged view of the area AA of FIG. 4.
FIG. 8 is a cross-sectional view of a display device taken along the line II-II' of FIG. 7.
FIG. 9 is an enlarged view of BB area the FIG. 4.
FIG. 10 is a cross-sectional view along the line III-III' of FIG. 9.
FIG. 11 is a plan view of a display panel.

### DETAILED DESCRIPTION

In the specification, the expression that a first component (or area, layer, part, portion, etc.) is "on", "connected with", or "coupled to" a second component means that the first component is directly on, connected with, or coupled to the second component or means that a third component is located therebetween.

The same reference numerals refer to the same components. Also, in drawings, the thickness, ratio, and dimension of components are exaggerated for effectiveness of description of technical contents. The expression "and/or" includes one or more combinations which associated components are capable of defining.

Although the terms "first", "second", etc. may be used to describe various components, the components should not be construed as being limited by the terms. The terms are used only to differentiate one component from another component. For example, without departing from the scope of the disclosure, a first component may be referred to as a second component, and similarly, a second component may be referred to as a first component. As used herein, singular forms may include plural forms as well unless the context clearly indicates otherwise.

Also, the terms "under", "below", "on", "above", etc. are used to describe the correlation of components illustrated in drawings. The terms are relative and are described with reference to a direction indicated in the drawing.

It will be further understood that the terms "comprises", "includes", "have", etc. specify the presence of stated features, numbers, steps, operations, elements, components, or a combination thereof but do not preclude the presence or addition of one or more other features, numbers, steps, operations, elements, components, or a combination thereof.

Unless otherwise defined, all terms (including technical terms and scientific terms) used in the specification have the same meaning as commonly understood by one skilled in the art to which the present disclosure belongs. In addition, the terms such as terms defined in the dictionaries commonly used should be interpreted as having a meaning consistent with the meaning in the context of the related technology, and should not be interpreted in ideal or overly formal meanings unless explicitly defined herein.

Hereinafter, embodiments of the present disclosure will be described with reference to accompanying drawings.

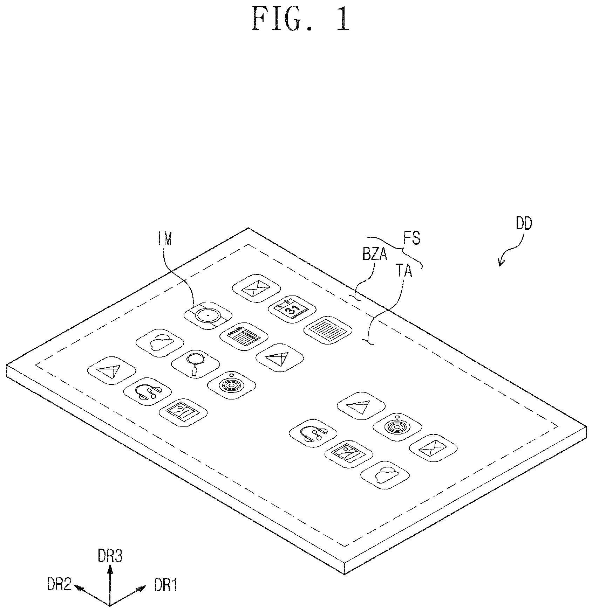

FIG. 1 is a perspective view of a display device DD.

Referring to FIG. 1, the display device DD may display an image IM on a display surface FS parallel to each of a first direction DR1 and a second direction DR2, so as to face a third direction DR3 (e.g., a direction normal or perpendicular to a plane defined by the first direction DR1 and the second direction DR2). The image IM may include a still image (e.g., a static image) as well as a moving image (e.g., a video image). A clock window and icons are illustrated in FIG. 1 as an example of the image IM. The display surface FS on which the image IM is displayed may correspond to a front surface of the display device DD.

A front surface (or an upper/top surface) and a rear surface (or a lower/bottom surface) of each member are defined with respect to a direction in which the image IM is displayed. The front surface and the rear surface may face away from each other in the third direction DR3, and the normal direction of each of the front surface and the rear surface may be parallel to the third direction DR3. Meanwhile, directions that the first, second, and third directions DR1, DR2, and DR3 indicate may be relative in concept and may be changed to different directions. In the specification, the expression "when viewed from above a plane" may mean "when viewed in the third direction DR3".

Although a tablet is shown as the display device DD in FIG. 1, the display device DD of the present disclosure may be various display devices DD without being limited thereto. For example, the display device DD of the present disclosure may be a television, a portable phone, a tablet, a computer, a navigation device, or the like, which has the display surface FS and displays the image IM. The display device DD of the present disclosure may be folded or rolled (e.g., without damaging the display device DD).

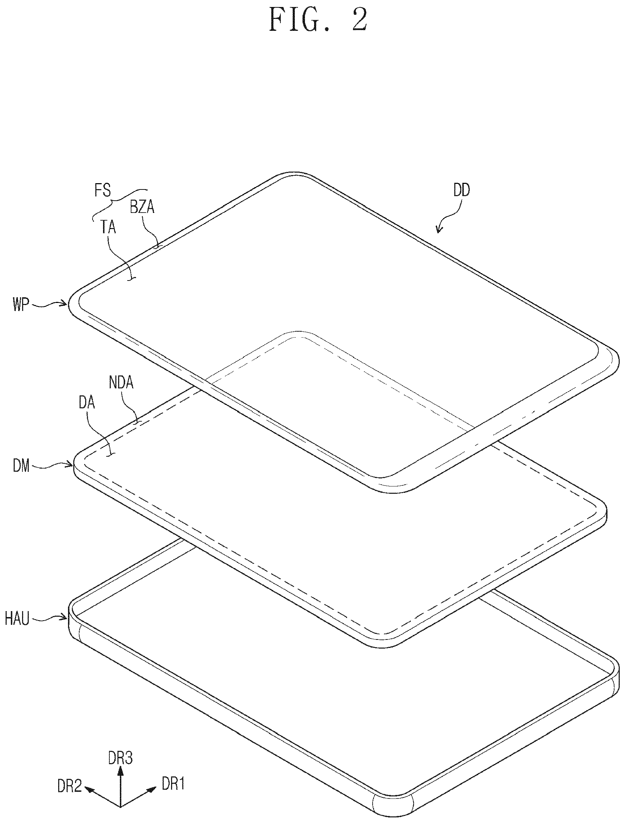

FIG. 2 is an exploded perspective view of the display device DD.

Referring to FIG. 2, the display device DD may include a window WP, a display module DM, and a housing HAU. The window WP and the housing HAU may be combined with each other to form the exterior of the display device DD.

The window WP may include an optically transparent material. For example, the window WP may include glass or plastic. A front surface of the window WP may define the display surface FS of the display device DD. The display surface FS may include a transmissive area TA and a bezel area BZA. The transmissive area TA may be an optically transparent area. For example, the transmissive area TA may be an area with a visible light transmittance of approximately 90% or more.

The bezel area BZA may be an area having relatively low light transmittance compared to the transmissive area TA. The bezel area BZA may define a shape of the transmissive area TA. The bezel area BZA may be adjacent to the transmissive area TA and may surround the transmissive area TA. Meanwhile, this is shown as an example, and in a window WP, the bezel area BZA may be omitted. The window WP may include at least one functional layer of an anti-fingerprint layer, a hard coating layer, and an anti-reflection layer, and is not limited to any one implementation.

The display module DM may be located under the window WP. The display module DM may be a component that substantially generates the image IM. The image IM generated by the display module DM may be displayed on a display surface IS of the display module DM and may be visually recognized by a user from the outside through the transmissive area TA.

The display module DM may include a display area DA and a non-display area NDA. The display area DA may be an area activated according to an electrical signal. The non-display area NDA may be adjacent to the display area DA. The non-display area NDA may surround the display area DA. The non-display area NDA may be an area covered by the bezel area BZA and may not be visible from the outside.

The housing HAU may be coupled to the window WP. The housing HAU may be coupled to the window WP to provide an inner space (e.g., a set or predetermined inner space). The display module DM may be accommodated in the inner space.

The housing HAU may include a material whose rigidity is relatively high. For example, the housing HAU may include glass, plastic, or metal or may include a plurality of frames and/or plates that are composed of a combination thereof. The housing HAU may stably protect components of the display device DD accommodated in the inner space from an external impact.

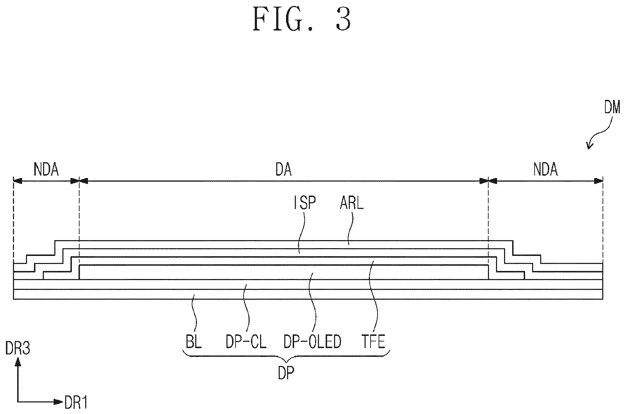

FIG. 3 is a cross-sectional view of a display module DM.

Referring to FIG. 3, the display module DM may include a display panel DP and an input sensor ISP. The display device DD (see FIG. 1) may further include a protective member located on the lower surface of the display panel DP or an anti-reflective member and/or a window member located on the upper surface of the input sensor ISP.

The display panel DP may be, but is not limited to, an emission-type display panel. For example, the display panel DP may be an organic light emitting display panel or an inorganic light emitting display panel. An emission layer in the organic light emitting display panel may include an organic luminescent material. The emission layer in the inorganic light emitting display panel may include quantum dots, quantum rods, or micro LEDs. Hereinafter, the display panel DP will be described as being an organic light emitting display panel.

The display panel DP may include a base substrate BL, a circuit element layer DP-CL located on the base substrate BL, a light-emitting element layer DP-OLED, and a thin film encapsulation layer TFE. The input sensor ISP may be located directly on the thin film encapsulation layer TFE. As used herein, "configuration A is located directly on configuration B" means that no adhesive layer is located between configuration A and configuration B.

The base substrate BL may include at least one plastic film. The base substrate BL may be a flexible substrate and may include a plastic substrate, a glass substrate, a metal substrate, or an organic/inorganic composite substrate. The display area DA and the non-display area NDA described with reference to FIG. 1 may be equally defined on the base substrate BL.

The circuit element layer DP-CL may include at least one insulating layer and a pixel circuit. The insulating layer may include at least one inorganic layer and at least one organic layer. The circuit element layer may include signal lines, pixel drive circuits, and the like.

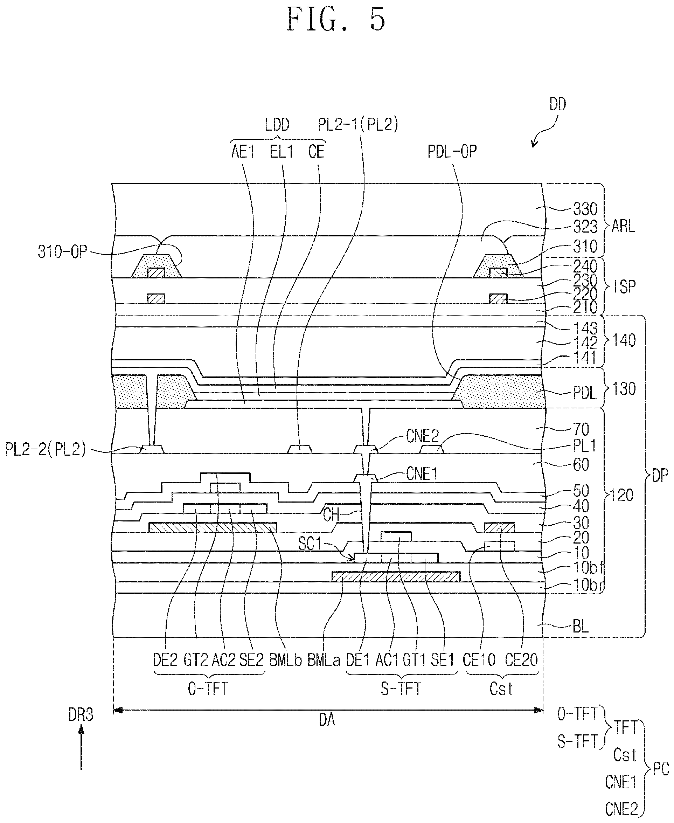

The light emitting element layer DP-OLED may include a conductive barrier wall and a light emitting element LDD (see FIG. 5). The light emitting element LDD (see FIG. 5) may include a first electrode AE1 (see FIG. 5), an emission layer EL1 (see FIG. 5), and a second electrode CE (see FIG. 5).

The thin film encapsulation layer TFE may include a plurality of thin films. Some of the thin films may be arranged to improve optical efficiency, and the others thereof may be arranged to protect the organic light-emitting diodes.

The input sensor ISP may acquire information on coordinates of an external input. The input sensor ISP may have a multilayer structure. The input sensor ISP may include a single or multiple conductive layers. The input sensor ISP may include a single or multiple insulating layers. The input sensor ISP may detect an external input in a capacitive method. The mode of operation of the input sensor ISP is not particularly limited in the present disclosure, and the input sensor ISP may detect an external input in an electromagnetic induction method or a pressure sensing method. The input sensor ISP may be omitted.

An anti-reflection layer ARL may be directly located on the input sensor ISP. The anti-reflection layer ARL may reduce a reflectance of external light incident from the outside of the display device DD (see FIG. 2). The anti-reflection layer ARL may include color filters. The color filters may have a given arrangement. For example, the color filters may be arranged in consideration of colors of lights emitted from pixels included in the display panel DP. Also, the anti-reflection layer ARL may further include a black matrix adjacent to the color filters.

The locations of the input sensor ISP and the anti-reflection layer ARL may be interchangeable. In an example of the present disclosure, the anti-reflection layer ARL may be replaced by a polarizing film. The polarizing film may be coupled to the input sensor ISP through an adhesive layer.

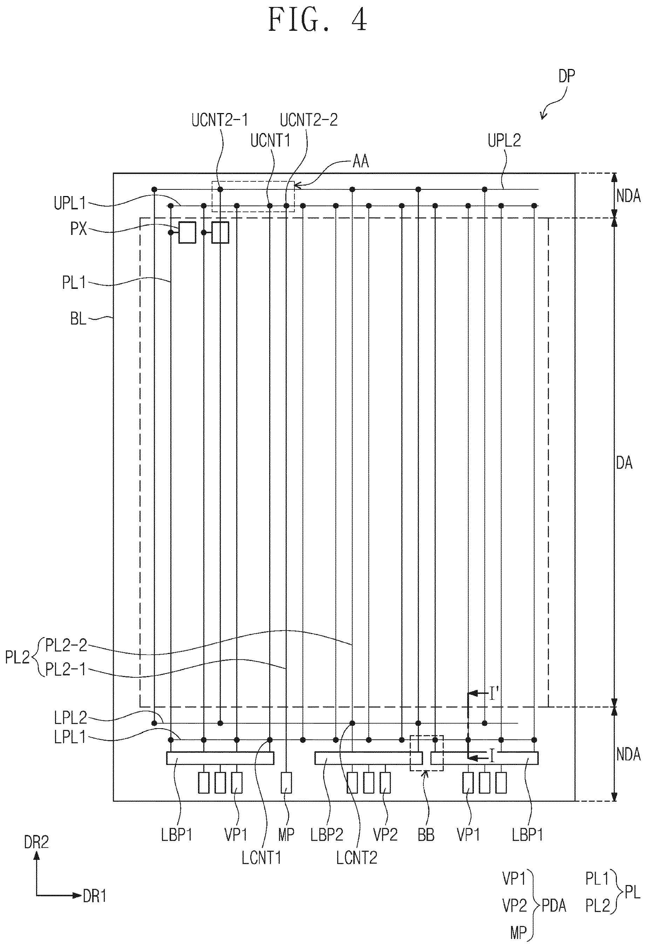

FIG. 4 is a plan view of the display panel DP.

Referring to FIG. 4, the display panel DP may include the base substrate BL divided into the display area DA and the non-display area NDA described above in FIG. 2.

The display panel DP may include pixels PX located in the display area DA and a plurality of first lines PL1 electrically connected to the pixels PX. Signal lines, gate lines, and control signal lines extending in the first direction DR1 may be connected to the pixels PX. Data lines extending in the second direction DR2 may be connected to the pixels PX. In the present disclosure, only the plurality of first lines PL1 and a plurality of second lines PL2 corresponding to a power line PL are shown, and the remaining lines connected to the pixels PX are omitted.

The pixels PX may be arranged in the first direction DR1 and the second direction DR2. The pixels PX may include a plurality of pixel rows extending in the first direction DR1 and arranged in the second direction DR2 and a plurality of pixel columns extending in the second direction DR2 and arranged in the first direction DR1.

A pad part PDA may include a first voltage pad VP1, a second voltage pad VP2, and a voltage measurement pad MP. The pad part PDA may be a part to which a flexible circuit board is connected. The pad part PDA may include various pads such as a data pad or an input pad, but only pads related to voltages provided to the pixels PX are shown in the present disclosure.

The pad part PDA may overlap the non-display area NDA. The pad part PDA may be located adjacent to a lower end of the display area DA. However, the arrangement of the pad part PDA is not limited thereto and may be arranged in various positions.

The first voltage pad VP1 may be located in the non-display area NDA to receive a first power voltage. The first voltage pad VP1 may be electrically connected to the pixels PX to provide the first power voltage to first electrodes AE1 of the pixels PX (see FIG. 5). A second voltage pad VP2 may be located in the non-display area NDA to receive a second power voltage different from the first power voltage. The second voltage pad VP2 may be electrically connected to the pixels PX to provide the second power voltage to second electrodes CE of the pixels PX (see FIG. 5). The voltage measurement pad MP may be located in the non-display area NDA and electrically connected to a first transfer line UPL1 to measure a voltage value of the first transfer line UPL1.

The display panel DP may include the plurality of first lines PL1 and the plurality of second lines PL2. The plurality of first lines PL1 may overlap the display area DA and extend in the second direction DR2. Each of the plurality of first lines PL1 may cross the display area DA in the second direction DR2. The plurality of first lines PL1 may extend in the second direction DR2 and be arranged in the first direction DR1. The plurality of first lines PL1 may be arranged in such a way that the single first line PL1 is arranged for each pixel column extending in the second direction DR2.

The plurality of first lines PL1 may be electrically connected to the first voltage pad VP1. Each of the plurality of first lines PL1 may be electrically connected to the plurality of pixels PX. One of the plurality of first lines PL1 may be electrically connected to the pixels PX constituting a pixel column extending in the second direction DR2. Each of the plurality of first lines PL1 may be electrically connected to the first electrode AE1 of the pixel PX (see FIG. 5) to supply the first power voltage.

The plurality of second lines PL2 may include at least one 2-1-th line PL2-1 (or connection line) and at least one 2-2-th line PL2-2. The plurality of second lines PL2 may overlap the display area DA and extend in the second direction DR2. Each of the plurality of second lines PL2 may cross the display area DA in the second direction DR2. The plurality of second lines PL2 may extend in the second direction DR2 and be arranged in the first direction DR1.

The plurality of second lines PL2 may be arranged in the first direction DR1 according to a rule (e.g., a set or predetermined rule). The plurality of second lines PL2 may be arranged in the first direction DR1 with a constant periodicity. For example, the plurality of second lines PL2 may be arranged to have the same minimum distances by which the plurality of second lines PL2 are spaced apart from each other in the first direction DR1. A minimum separation distance between the second lines closest to each other among the plurality of second lines PL2 may be the first distance or a second distance different from the first distance. The plurality of second lines PL2 may be arranged such that thick lines and thin lines are alternately arranged in the first direction DR1.

Unlike the plurality of first lines PL1, the plurality of second lines PL2 may not need to be arranged in such a way that the single second line PL2 is arranged for each of pixel columns arranged in the second direction DR2. As shown in FIG. 4, one second line PL2 may not be arranged for each pixel column.

Among the plurality of second lines PL2, the 2-1-th line PL2-1 may be electrically connected to the voltage measurement pad MP. The 2-1-th line PL2-1 may be electrically connected to the first transfer line UPL1. Although it is shown in FIG. 4 that there is one 2-1-th line PL2-1, there may be a plurality of 2-1-th lines PL2-1.

That is, the 2-1-th line PL2-1 may electrically connect the voltage measurement pad MP and the first transfer line UPL1. Because the 2-1-th line PL2-1 is arranged to overlap the display area DA, the 2-1-th line PL2-1 may connect the voltage measurement pad MP and the first transfer line UPL1 at a minimum distance. That is, the 2-1-th line PL2-1 may connect the voltage measurement pad MP and the first transfer line UPL1 at a distance with a shorter length than a case where the 2-1-th line PL2-1 connects the voltage measurement pad MP and the first transfer line UPL1 by bypassing the display area DA. Accordingly, the resistance of the 2-1-th line PL2-1 may be lowered.

Because the 2-1-th line PL2-1 overlaps the display area DA, a space of the non-display area NDA may be reduced, compared to a case where the 2-1-th line PL2-1 overlaps the non-display area NDA. In addition, because some of the plurality of second lines PL2 having a low resistance are used as the 2-1-th line PL2-1, the resistance value may be lowered. A detailed description thereof will be given later.

As described above, when the resistance of the 2-1-th line PL2-1 is lowered, the reliability of the voltage drop value of the first power voltage measured by the voltage measurement pad MP may be improved. Here, the voltage drop value may be a voltage value that is reduced by resistors in the process of transferring the first power voltage of the first voltage pad VP1 to the first transfer line UPL1 through the plurality of first lines PL1. When the resistance of the 2-1-th line PL2-1 is large, the voltage drop value measured by the voltage measurement pad MP may be different from an actual voltage drop value. In the present disclosure, because the resistance of the 2-1-th line PL2-1 is low, the difference between the actual voltage drop value and a measured value may be reduced to improve the measurement reliability of the voltage measurement pad MP.

Among the plurality of second lines PL2, the 2-2-th line PL2-2 may be electrically connected to the second voltage pad VP2. The 2-2-th line PL2-2 may be electrically connected to a second transfer line UPL2. That is, the 2-2-th line PL2-2 may electrically connect the second voltage pad VP2 and the second transfer line UPL2. The 2-2-th line PL2-2 may be electrically connected to the second electrode CE of the pixel PX (see FIG. 5) to supply the second power voltage.

The minimum separation distance between the plurality of 2-2-th lines PL2-2 may be the same as the minimum separation distance between the 2-1-th line PL2-1 and the 2-2-th line PL2-2 closest to the 2-1-th line PL2-1 among the 2-2-th lines PL2-2.

The display panel DP may include the first transfer line UPL1, the second transfer line UPL2, a third transfer line LPL1, and a fourth transfer line LPL2. The first transfer line UPL1 and the third transfer line LPL1 may be connected to each of the plurality of first lines PL1 to allow the first power voltage of the first voltage pad VP1 to be equally distributed to the plurality of first lines PL1. The second transfer line UPL2 and the fourth transfer line LPL2 may be connected to each of the plurality of second lines PL2-2 to allow the second power voltage of the second voltage pad VP2 to be equally distributed to the plurality of 2-2-th lines PL2-2.

The first transfer line UPL1 may be electrically connected to each of the plurality of first lines PL1 and may extend in the first direction DR1. The first transfer line UPL1 may overlap the non-display area NDA and may be located adjacent to an upper side of the display area DA. That is, the display area DA may be located between the first transfer line UPL1 and the first voltage pad VP1. The first transfer line UPL1 may be located on a layer different from each of the plurality of first lines PL1 in cross section. This will be described later with reference to the cross-sectional view of FIG. 5.

The first transfer line UPL1 may be electrically connected to an upper end of each of the plurality of first lines PL1. The first transfer line UPL1 may be electrically connected to each of the plurality of first lines PL1 through a first upper contact hole UCNT1.

The first transfer line UPL1 may be electrically connected to the 2-1-th line PL2-1 of the plurality of second lines PL2. The first transfer line UPL1 may be electrically connected to the 2-1-th line PL2-1 through a 2-2-th upper contact hole UCNT2-2. Accordingly, the voltage value of the first transfer line UPL1 may be transmitted to the voltage measurement pad MP through the 2-1-th line PL2-1, and the voltage measurement pad MP may measure a voltage value of the first transfer line UPL1.

The second transfer line UPL2 may be electrically connected to at least one 2-2-th line PL2-2 and may extend in the first direction DR1. The second transfer line UPL2 may overlap the non-display area NDA and may be located adjacent to the upper side of the display area DA. The second transfer line UPL2 may be spaced apart from the first transfer line UPL1 in the second direction DR2 by a distance (e.g., a set or predetermined distance). The display area DA may be located between the second transfer line UPL2 and the second voltage pad VP2. The second transfer line UPL2 may be located on a layer different from each of the plurality of second lines PL2 in cross section.

The second transfer line UPL2 may be electrically connected to an upper end of each of the plurality of 2-2-th lines PL2-2. The second transfer line UPL2 may be electrically connected to each of the plurality of 2-2-th lines PL2-2 through a 2-1-th upper contact hole UCNT2-1.

The third transfer line LPL1 may be connected to the plurality of first lines PL1 and may extend in the first direction DR1. The third transfer line LPL1 may be located between the first voltage pad VP1 and the display area DA. The third transfer line LPL1 may overlap the non-display area NDA and may be located adjacent to a lower side of the display area DA. The third transfer line LPL1 may be located on a layer different from the plurality of first lines PL1 in cross section.

The third transfer line LPL1 may be electrically connected to a lower end of each of the plurality of first lines PL1. The third transfer line LPL1 may be electrically connected to each of the plurality of first lines PL1 through a first lower contact hole LCNT1.

The fourth transfer line LPL2 may be connected to the plurality of 2-2-th lines PL2-2 and may extend in the first direction DR1. The fourth transfer line LPL2 may be located between the second voltage pad VP2 and the display area DA. The fourth transfer line LPL2 may overlap the non-display area NDA and may be located adjacent to a lower side of the display area DA. The fourth transfer line LPL2 may be located on a layer different from the plurality of second lines PL2 in cross section.

The fourth transfer line LPL2 may be electrically connected to a lower end of each of the plurality of 2-2-th lines PL2-2. The fourth transfer line LPL2 may be electrically connected to each of the plurality of 2-2-th lines PL2-2 through a second lower contact hole LCNT2.

The display panel DP may include a first voltage transfer line LBP1 and a second voltage transfer line LBP2. The first voltage transfer line LBP1 may be connected to some of the plurality of first lines PL1 and may extend in the first direction DR1. The first voltage transfer line LBP1 may be located between the third transfer line LPL1 and the first voltage pad VP1.

As shown in FIG. 4, the first voltage transfer line LBP1 may have a greater thickness in the second direction DR2 than those of the first to fourth transfer lines UPL1, UPL2, LPL1, and LPL2. Accordingly, the resistance of the first voltage transfer line LBP1 may be smaller than the resistances of the first to fourth transfer lines UPL1, UPL2, LPL1, and LPL2. Because the first voltage transfer line LBP1 has a low resistance, the first power voltage of the first voltage pad VP1 may be smoothly transferred to the plurality of first lines PL1.

The second voltage transfer line LBP2 may be connected to some of the plurality of second lines PL2 and may extend in the first direction DR1. The second voltage transfer line LBP2 may be located between the fourth transfer line LPL2 and the second voltage pad VP2.

As shown in FIG. 4, the second voltage transfer line LBP2 may have a greater thickness in the second direction DR2 than those of the first to fourth transfer lines UPL1, UPL2, LPL1, and LPL2. Accordingly, the resistance of the second voltage transfer line LBP2 may be smaller than the resistances of the first to fourth transfer lines UPL1, UPL2, LPL1, and LPL2. Because the second voltage transfer line LBP2 has a low resistance value, the second power voltage of the second voltage pad VP2 may be smoothly transferred to the plurality of second lines PL2. However, the first voltage transfer line LBP1 and the second voltage transfer line LBP2 described above may be omitted if necessary.

FIG. 5 is a cross-sectional view of the display device DD.

Referring to FIG. 5, a cross-sectional view corresponding to the display area DA of the display device DD is shown. A pixel PX (see FIG. 4) located on the display device DD may include a pixel circuit PC including a transistor TFT and a light emitting element LDD electrically connected to the pixel circuit PC.

Referring to FIG. 5, a barrier layer 10br may be located on the base substrate BL. The barrier layer 10br may prevent or reduce instances of foreign substances or contaminants entering from the outside. The barrier layer 10br may include at least one inorganic layer. The barrier layer 10br may include a silicon oxide layer and a silicon nitride layer. Each of the silicon oxide layer and the silicon nitride layer may include a plurality of layers, and the plurality of silicon oxide layers and the plurality of silicon nitride layers may be alternately stacked.

A first shielding electrode BMLa may be located on the barrier layer 10br. The first shielding electrode BMLa may include metal. The first shielding electrode BMLa may include molybdenum (Mo), an alloy containing molybdenum, titanium (Ti), or an alloy containing titanium, which has good heat resistance. The first shielding electrode BMLa may receive a bias voltage. The first shielding electrode BMLa may receive a first power supply voltage ELVDD. The first shielding electrode BMLa may prevent or reduce instances of an electrical potential due to a polarization phenomenon affecting a silicon transistor S-TFT. The first shielding electrode BMLa may prevent or reduce instances of an external light being incident onto the silicon transistor S-TFT. The first shielding electrode BMLa may be a floating electrode that is isolated from any other electrode or wire.

A buffer layer 10bf may be located on the barrier layer 10br. The buffer layer 10bf may prevent or reduce instances of metal atoms, contaminants, or impurities being diffused from the base substrate BL to a first semiconductor pattern SC1 on the upper side thereof. The buffer layer 10bf may include at least one inorganic layer. The buffer layer 10bf may include a silicon oxide layer and a silicon nitride layer.

The first semiconductor pattern SC1 may be located on the buffer layer 10bf. The first semiconductor pattern SC1 may include a silicon semiconductor. For example, the silicon semiconductor may include amorphous silicon or polycrystalline silicon. For example, the first semiconductor pattern SC1 may include low-temperature polycrystalline silicon (LTPS).

FIG. 5 shows only a portion of the first semiconductor pattern SC1, and the first semiconductor pattern SC1 may be further located in any other area. The first semiconductor patterns SC1 may be arranged according to pixels in compliance with a specific rule. An electrical property of the first semiconductor pattern SC1 may vary depending on whether it is doped. The first semiconductor pattern SC1 may include a first area whose conductivity is high and a second area whose conductivity is low. The first area may be doped with an N-type dopant or a P-type dopant. A P-type transistor may include a doping area doped with the P-type dopant, and an N-type transistor may include a doping area doped with the N-type dopant. The second area may be a non-doping area or may be an area doped at a concentration lower than the concentration of the first area.

The conductivity of the first area may be higher than the conductivity of the second area, and the first area may substantially serve as an electrode or a signal line. The second area may substantially correspond to a channel area (or an active area) of a transistor. In other words, a portion of the first semiconductor pattern SC1 may be a channel of a transistor, another portion thereof may be a source or a drain of the transistor, and the other portion thereof may be a connection electrode or a connection signal line.

A first source area SE1, a channel area (or an active area) AC1, and a first drain area DE1 of the silicon transistor S-TFT may be formed from the first semiconductor pattern SC1. The first source area SE1 and the first drain area DE1 of the silicon transistor S-TFT may extend from the first channel area AC1 in directions, which are opposite to each other, in a cross-sectional view.

A first insulating layer 10 may be located on the buffer layer 10bf. The first insulating layer 10 may cover the first semiconductor pattern SC1. The first insulating layer 10 may be located between the first semiconductor pattern SC1 and a first gate GT1. The first insulating layer 10 may be an inorganic layer. The first insulating layer 10 may be a single silicon oxide layer. As well as the first insulating layer 10, the circuit layer 120 to be described later may include an inorganic layer of a single-layer or multi-layer structure and may include at least one of the above materials, but the present disclosure is not limited thereto.

The first gate GT1 of the silicon transistor S-TFT may be located on the first insulating layer 10. The first gate GT1 may be a portion of a metal pattern. The first gate GT1 may overlap the first channel area AC1. In a process of doping the first semiconductor pattern SC1, the first gate GT1 may be used as a mask. A tenth electrode CE10 of a storage capacitor Cst may be located on the first insulating layer 10. Unlike the illustration of FIG. 5, the tenth electrode CE10 may have an integral shape with the first gate GT1.

A second insulating layer 20 may be located on the first insulating layer 10 to cover the first gate GT1. An upper electrode that overlaps the first gate GT1 may be located on the second insulating layer 20. A twentieth electrode CE20 that overlaps the first electrode CE10 may be located on the second insulating layer 20.

A second shielding electrode BMLb may be located on the second insulating layer 20. The second shielding electrode BMLb may be arranged to correspond to a lower portion of an oxide transistor O-TFT. The second shielding electrode BMLb may be omitted. The first shielding electrode BMLa may extend to the lower portion of the oxide transistor O-TFT so as to be arranged under the oxide transistor O-TFT and thus may replace the second shielding electrode BMLb.

A third insulating layer 30 may be located on the second insulating layer 20. A second semiconductor pattern SC2 may be located on the third insulating layer 30. The third insulating layer 30 may be located between the first gate GT1 and the second semiconductor pattern SC2. The second semiconductor pattern SC2 may include a second channel area AC2 of the oxide transistor O-TFT. The second semiconductor pattern SC2 may include an oxide semiconductor. The second semiconductor pattern SC2 may include transparent conductive oxide (TCO) such as indium tin oxide (ITO), indium zinc oxide (IZO), indium gallium zinc oxide (IGZO), zinc oxide (ZnOX), or indium oxide (In2O3).

The oxide semiconductor may include a plurality of areas that are distinguished depending on whether the transparent conductive oxide is reduced. An area (hereinafter referred to as a "reduction area") in which the transparent conductive oxide is reduced has greater conductivity than an area (hereinafter referred to as a "non-reduction area") in which the transparent conductive oxide is not reduced. The reduction area may substantially serve as a source/drain of a transistor or a signal line. The non-reduction area substantially corresponds to a semiconductor area (or a channel) of a transistor. In other words, a portion of the second semiconductor pattern SC2 may be a semiconductor area of a transistor, another portion thereof may be a source area/ drain area of the transistor, and the other portion thereof may be a signal transfer area.

A fourth insulating layer 40 may be located on the third insulating layer 30. The fourth insulating layer 40 may cover the second semiconductor pattern SC2. A second gate GT2 of the oxide transistor O-TFT may be located on the fourth insulating layer 40. The second gate GT2 may be a portion of a metal pattern. The second gate GT2 may overlap the second channel area AC2. In the process of doping the second semiconductor pattern SC2, the second gate GT2 may be used as a mask.

A fifth insulating layer 50 may be located on the fourth insulating layer 40, and the fifth insulating layer 50 may cover the second gate GT2. Each of the first insulating layer 10 to the fifth insulating layer 50 may be an inorganic layer.

A first connection electrode CNE1 may be located on the fifth insulating layer 50. The first connection electrode CNE1 may be electrically connected with the first drain area DE1 of the silicon transistor S-TFT through a contact hole CH penetrating the first to fifth insulating layers 10, 20, 30, 40, and 50.

A sixth insulating layer 60 may be located on the fifth insulating layer 50. A second connection electrode CNE2 may be located on the sixth insulating layer 60. The sixth insulating layer 60 may cover the first connection electrode CNE1. The second connection electrode CNE2 may be electrically connected to the first connection electrode CNE1 through a contact hole CH passing through the sixth insulating layer 60.

The first line PL1 and the second line PL2 may be located on the sixth insulating layer 60. The first line PL1 and the second line PL2 may be located on the same layer as the second connection electrode CNE2 and may include the same material as the second connection electrode CNE2. The first line PL1 and the second line PL2 may include aluminum and titanium. The first line PL1 and the second line PL2 may be a laminate in which aluminum, titanium, and aluminum are sequentially stacked. Here, aluminum may serve to transmit voltage due to its low resistance. Titanium may serve as a protective film to prevent or reduce oxidation of aluminum.

The seventh insulating layer 70 may be located on the sixth insulating layer 60 to cover the second connection electrode CNE2, the first line PL1, and the second line PL2. Each of the sixth insulating layer 60 and the seventh insulating layer 70 may be an organic layer. The sixth insulating layer 60 and the seventh insulating layer 70 may cover the pixel circuit PC.

The light emitting element LDD may be located on the seventh insulating layer 70. The light emitting element LDD may include an anode (or a first electrode) AE1, an emission layer EL1, and a cathode (or a second electrode) CE. The cathodes CE of the plurality of light emitting elements LDD may have an integral shape. That is, the cathodes CE may be commonly provided to the plurality of light emitting elements LDD.

The anode AE1 of the light emitting element LDD may be located on the seventh insulating layer 70. The anode AE1 may be a (semi) light-transmitting electrode or a reflective electrode. A pixel defining layer PDL may be located on the seventh insulating layer 70. The pixel defining layer PDL may include the same material and may be formed through the same process. The pixel defining layer PDL may have a property of absorbing light. For example, the pixel defining layer PDL may have a black color. The pixel defining layer PDL may include a black coloring agent. The black coloring agent may include a black dye and a black pigment. The black coloring agent may include a metal, such as carbon black or chromium, or an oxide thereof. The pixel defining layer PDL may correspond to a light blocking pattern having a light blocking characteristic.

The pixel defining layer PDL may cover a portion of the anode AE1. For example, an opening PDL-OP that exposes a portion of the anode AE1 may be defined in the pixel defining layer PDL. The emission layer EL1 may be located on the anode AE1 to emit light. The cathode CE may be located on the emission layer EL1 to cover the emission layer EL1.

A hole control layer may be located between the anode AE1and the emission layer EL1. The hole control layer may include a hole transport layer and may further include a hole injection layer. An electron control layer may be located between the emission layer EL1 and the cathode CE. The electron control layer may include an electron transport layer and may further include an electron injection layer. The hole control layer and the electron control layer may be formed in common in the plurality of pixels PX (refer to FIG. 4) by using an open mask.

An encapsulation layer 140 may be located on a light emitting element layer 130. The encapsulation layer 140 may include an inorganic layer 141, an organic layer 142, and an inorganic layer 143 that are sequentially stacked, but the layers constituting the encapsulation layer 140 are not limited thereto.

The inorganic layers 141 and 143 may protect the light emitting element layer 130 from moisture and oxygen, and the organic layer 142 may protect the light emitting element layer 130 from a foreign substance such as dust particles. The inorganic layer 141 and the inorganic layer 143 may include a silicon nitride layer, a silicon oxynitride layer, a silicon oxide layer, a titanium oxide layer, or an aluminum oxide layer. The organic layer 142 may include, but is not limited to, an acryl-based organic layer.

The input sensor ISP may be located on the display panel DP. The input sensor ISP may include at least one conductive layer and at least one insulating layer. The input sensor ISP may include a first input insulating layer 210, a first conductive layer 220, a second input insulating layer 230, and a second conductive layer 240.

The first input insulating layer 210 may be directly located on the display panel DP. The first input insulating layer 210 may be an inorganic layer including at least one of silicon nitride, silicon oxynitride, or silicon oxide. Each of the first conductive layer 220 and the second conductive layer 240 may have a single-layer structure or may have a multi-layer structure in which a plurality of layers are stacked along the third direction DR3. The first conductive layer 220 and the second conductive layer 240 may include conductive lines defining electrodes of a mesh shape. The conductive line of the first conductive layer 220 and the conductive line of the second conductive layer 240 may be connected with each other through a contact hole penetrating the second input insulating layer 230 or may not be connected with each other. A connection relationship between the conductive line of the first conductive layer 220 and the conductive line of the second conductive layer 240 may be determined depending on a kind of a sensor implemented with the input sensor ISP.

Each of the first conductive layer 220 and the second conductive layer 240 that have a single-layer structure may include a metal layer or a transparent conductive layer. The metal layer may include molybdenum, silver, titanium, copper, aluminum, or the alloy thereof. The transparent conductive layer may include a transparent conductive oxide such as indium tin oxide (ITO), indium zinc oxide (IZO), zinc oxide (ZnOX), or indium zinc tin oxide (IZTO). In addition, the transparent conductive layer may include conductive polymer such as PEDOT, a metal nano-wire, graphene, or the like.

Each of the first conductive layer 220 and the second conductive layer 240 that have a multi-layer structure may include metal layers. The metal layers may have, for example, a three-layer structure of titanium/aluminum/titanium. The conductive layer of the multi-layer structure may include at least one metal layer and at least one transparent conductive layer. The second input insulating layer 230 may be located between the first conductive layer 220 and the second conductive layer 240.

The anti-reflection layer ARL may be located on the input sensor ISP. The anti-reflection layer ARL may include a division layer 310, a color filter 320, and a planarization layer 330.

A material forming the division layer 310 is not particularly limited as long as it is a material that absorbs light. The division layer 310 may be a layer having a black color; the division layer 310 may include a black coloring agent. The black coloring agent may include a black dye and a black pigment. The black coloring agent may include a metal, such as carbon black or chromium, or an oxide thereof.

The division layer 310 may cover the second conductive layer 240 of the input sensor ISP. The division layer 310 may prevent or reduce reflection of the external light by the second conductive layer 240. An opening 310-OP may be defined in the division layer 310 . The opening 310-OP may overlap the anode AE1. The color filter 320 may overlap the opening 310-OP. The color filter 320 may contact the division layer 310.

The planarization layer 330 may cover the division layer 310 and the color filter 320. The planarization layer 330 may include an organic material and may provide a flat surface on an upper surface of the planarization layer 330. The planarization layer 330 may be omitted.

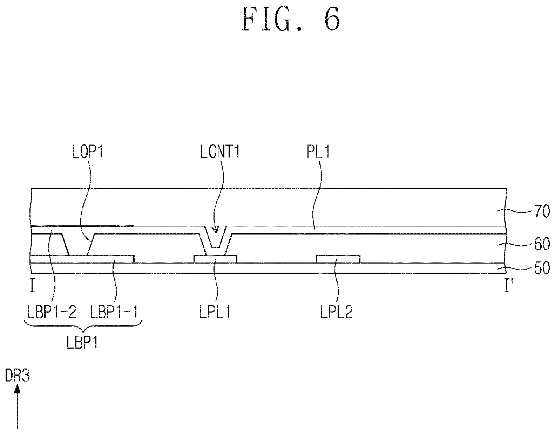

FIG. 6 is a cross-sectional view of a display device taken along the line I-I' of FIG. 4,.

Referring to FIG. 6, the first voltage transfer line LBP1 may be double wires. The first voltage transfer line LBP1 may include a 1-1-TH voltage transfer line LBP1-1 and a 1-2-th voltage transfer line LBP1-2. The 1-1-th voltage transfer line LBP1-1 may be located on the fifth insulating layer 50 and covered by the sixth insulating layer 60. The 1-2-th voltage transfer line LBP1-2 may be located on the sixth insulating layer 60 and covered by the seventh insulating layer 70. The 1-1-th voltage transfer line LBP1-1 and the 1-2-th voltage transfer line LBP1-2 may be connected by a first contact hole LOP1 passing through the sixth insulating layer 60. In this way, the first voltage transfer line LBP1 may be formed as double wires to have a lower resistance.

The 1-2-th voltage transfer line LBP1-2 and the first line PL1 may be located on the same layer and contact each other. The first line PL1 may be electrically connected to the third transfer line LPL1 through the first lower contact hole LCNT1 passing through the sixth insulating layer 60. Because the first line PL1 and the fourth transfer line LPL2 are located on different layers, the first line PL1 and the fourth transfer line LPL2 may not be electrically connected to each other. As described above, the first voltage transfer line LBP1, the first line PL1, and the third transfer line LPL1 may be connected. Accordingly, the first power voltage of the first voltage pad VP1 may be transferred to the plurality of first lines PL1 (see FIG. 4) and the first transfer line UPL1.

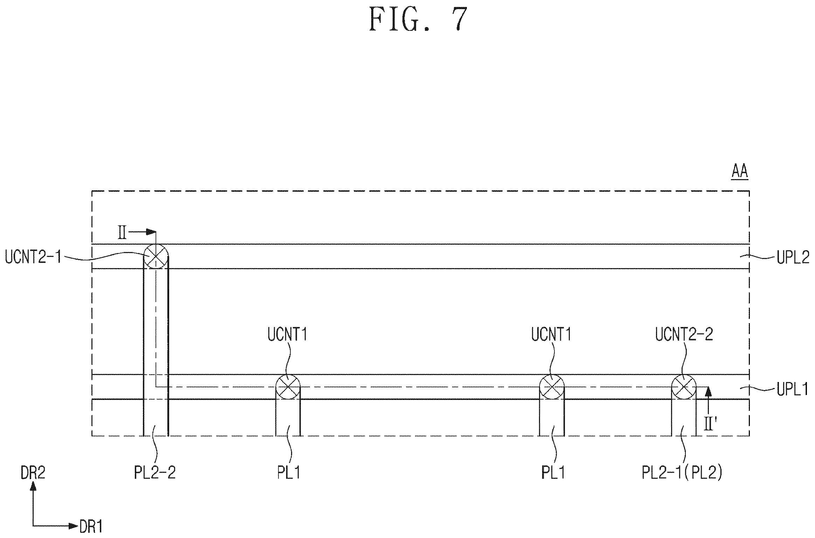

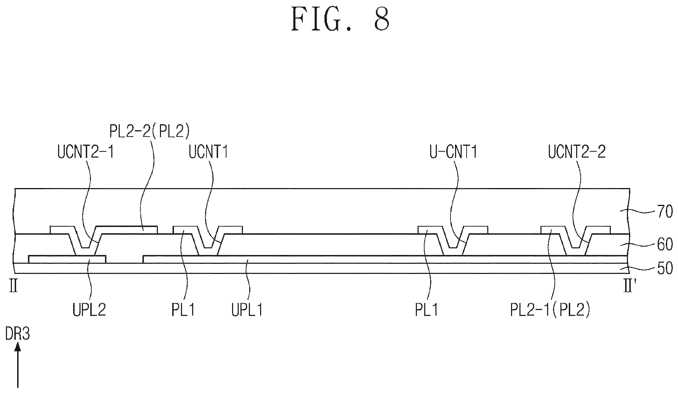

FIG. 7 is an enlarged view of the area AA of FIG. 4. FIG. 8 is a cross-sectional view along the line II-II' of FIG. 7.

Referring to FIGS. 7 and 8, the 2-2-th line PL2-2 may be connected to the second transfer line UPL2 through the 2-1-th upper contact hole UCNT2-1 passing through the sixth insulating layer 60. As a result, the second power voltage of the second voltage pad VP2 (see FIG. 4) may be transferred to the second transfer line UPL2 through the 2-2-th line PL2-2. The 2-2-th line PL2-2 may not be electrically connected to the first transfer line UPL1 because the 2-2-th line PL2-2 is located on a different layer from the first transfer line UPL1.

The first line PL1 may be electrically connected to the first transfer line UPL1 through the first upper contact hole UCNT1 passing through the sixth insulating layer 60. The 2-1-th line PL2-1 may be connected to the first transfer line UPL1 through the 2-2-th upper contact hole UCNT2-2 passing through the sixth insulating layer 60. As described above, because the first line PL1, the 2-1-th line PL2-1, and the first transfer line UPL1 are connected, the first power voltage of the first voltage pad VP1 (see FIG. 4) may be transferred to the 2-1-th line PL2-1 and the first transfer line UPL1 through the first line PL1.

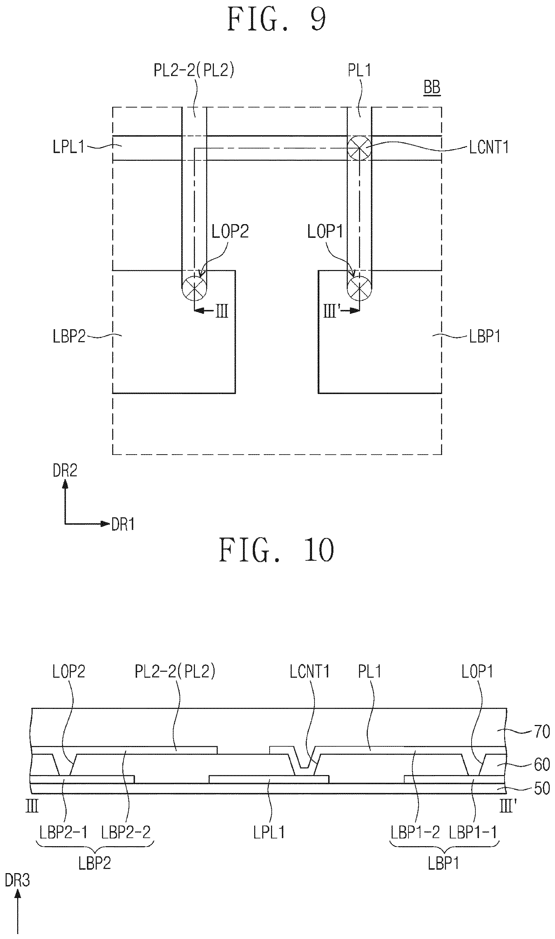

FIG. 9 is an enlarged view of an area BB of FIG. 4. FIG. 10 is a cross-sectional view along the line III-III' of FIG. 9.

Referring to FIGS. 9 and 10, the second voltage transfer line LBP2 may include a 2-1-th voltage transfer line LBP2-1 and a 2-2-th voltage transfer line LBP2-2. The 2-1-th voltage transfer line LBP2-1 may be located on the fifth insulating layer 50 and covered by the sixth insulating layer 60. The 2-2-th voltage transfer line LBP2-2 may be located on the sixth insulating layer 60 and covered by the seventh insulating layer 70. The 2-1-th voltage transfer line LBP2-1 and the 2-2-th voltage transfer line LBP2-2 may be electrically connected by a second contact hole LOP2 passing through the sixth insulating layer 60.

Because the 2-2-th line PL2-2 and the 2-2-th voltage transfer line LBP2-2 are located on the sixth insulating layer 60, the 2-2-th line PL2-2 and the 2-2-th voltage transfer line LBP2-2 may be electrically connected without a separate contact hole. Because the first line PL1 and a 1-2-th voltage transfer lines LBP1-2 are located on the sixth insulating layer 60, the first line PL1 and the 1-2-th voltage transfer lines LBP1-2 may be electrically connected without a separate contact hole. The first line PL1 may be connected by the first lower contact hole LCNT1 passing through the sixth insulating layer 60.

The 2-2-th line PL2-2 and the fourth transfer line LPL2 (see FIG. 4) may be electrically connected through the second lower contact hole LCNT2 (see FIG. 4) passing through the sixth insulating layer 60.

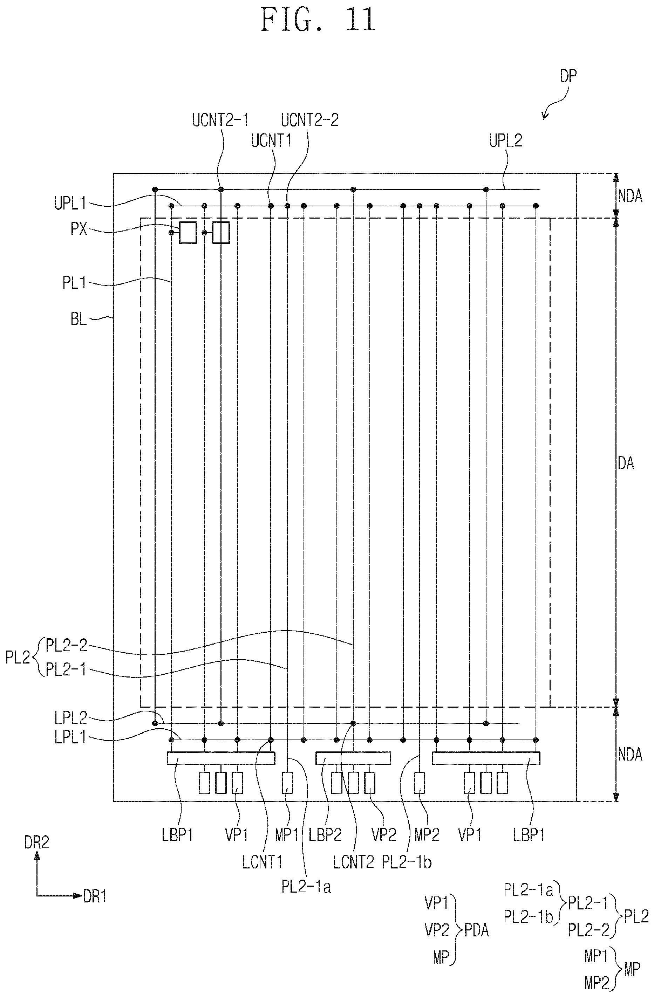

FIG. 11 is a plan view of a display panel.

Because a display panel in FIG. 11 is the same as the display panel DP described with reference to FIG. 4 except for the number of 2-1-th lines PL2-1, the same reference numerals are used for the same components, and descriptions thereof are omitted.

The plurality of 2-1-th lines PL2-1 may be provided. As shown in FIG. 11, the 2-1-th lines PL2-1 may include a 2-1a-th line PL2-1a and a 2-1b-th line PL2-1b. It is noted that, this is merely an example of the 2-1-th line PL2-1, and the number of 2-1-th lines PL2-1 may be increased or decreased as needed.

The 2-1a-th line PL2-1a may be electrically connected to a first voltage measurement pad MP1 and the first transfer line UPL1. The 2-1b-th line PL2-1b may be electrically connected to a second voltage measurement pad MP2 and the first transfer line UPL1. In this case, because a voltage value of the first transfer line UPL1 is measured by both the first voltage measurement pad MP1 and the second voltage measurement pad MP2, reliability of a measured voltage may be improved compared to a case where only one voltage measurement pad MP is used.

Although described above with reference to some embodiments of the present disclosure, it will be understood by those skilled in the art that various modifications and changes can be made to the embodiments of the present disclosure without departing from the scope of the invention as set forth in the claims below.

According to some embodiments as described above, a line connecting the voltage measurement pad and the first transfer line is arranged to overlap the display area, thereby reducing the length of the line and the resistance value of the line.

In addition, the line connecting the voltage measurement pad and the first transfer line may be made of a material with low resistance, thereby reducing the resistance value. Accordingly, the reliability of the voltage value measured by the voltage measurement pad may be improved.

## Claims

1. A display device comprising:
a base substrate including a display area in which a plurality of pixels are located and a non-display area;
a plurality of insulating layers on the base substrate;
a pad part including a first voltage pad in the non-display area and configured to receive a first power voltage, a second voltage pad configured to receive a second power voltage different from the first power voltage, and a voltage measurement pad;
a plurality of first lines electrically connected to the plurality of pixels, overlapping the display area, extending in a first direction, and electrically connected to the first voltage pad;
a plurality of second lines overlapping the display area and extending in the first direction;
a first transfer line electrically connected to each of the plurality of first lines and extending in a second direction crossing the first direction; and
a second transfer line extending in the second direction and overlapping the non-display area,
wherein the display area is between the first transfer line and the first voltage pad,
wherein the display area is between the second transfer line and the second voltage pad,
wherein the plurality of second lines include at least one 2-1-th line and at least one 2-2-th line,
wherein the 2-1-th line is electrically connected to the voltage measurement pad and electrically connected to the first transfer line,
wherein the 2-2-th line is electrically connected to the second voltage pad and electrically connected to the second transfer line.

2. The display device of claim 1, wherein each of the plurality of pixels includes:
a pixel circuit on the base substrate and including a transistor; and
a light emitting element electrically connected to the pixel circuit,
wherein the plurality of insulating layers include an organic insulating layer covering the plurality of first lines, the plurality of second lines, and the pixel circuit, and the light emitting element is on the organic insulating layer.

3. The display device of claim 2, wherein the transistor includes:
a silicon transistor including a silicon semiconductor pattern and a first gate overlapping the silicon semiconductor pattern; and
an oxide transistor including an oxide semiconductor pattern and a second gate overlapping the oxide semiconductor pattern,
wherein the pixel circuit includes:
a first connection electrode electrically connected to the silicon semiconductor pattern of the silicon transistor; and
a second connection electrode connected to the first connection electrode,
wherein the plurality of insulating layers include:
a first insulating layer between the silicon semiconductor pattern and the first gate;
a second insulating layer covering the first gate and between the first gate and the oxide semiconductor pattern;
a third insulating layer covering the second gate;
a fourth insulating layer covering the first connection electrode; and
a fifth insulating layer covering the second connection electrode.

4. The display device of claim 2 or 3, wherein the light emitting element includes:
a first electrode on an uppermost insulating layer among the plurality of insulating layers;
an emission layer on the first electrode to emit light; and
a second electrode on the emission layer to cover the emission layer,
wherein the plurality of first lines are electrically connected to the first electrode, and the 2-2-th line of the plurality of second lines is electrically connected to the second electrode.

5. The display device of claim 3 or 4, wherein each of the plurality of second lines includes the same material as the second connection electrode.

6. The display device of claim 3, 4 or 5, further comprising:
a third transfer line connected to the plurality of first lines, extending in the second direction, and located between the first voltage pad and the display area; and
a fourth transfer line connected to the plurality of second lines, extending in the second direction, and located between the second voltage pad and the display area.

7. The display device of any one of claims 3 to 6, wherein the plurality of first lines and the plurality of second lines are on the fourth insulating layer and covered by the fifth insulating layer.

8. The display device of any one of claims 3 to 7, wherein the first transfer line and the second transfer line are on the third insulating layer and covered by the fourth insulating layer.

9. The display device of claim 6, wherein the third transfer line and the fourth transfer line are on the third insulating layer and covered by the fourth insulating layer.

10. The display device of claim 6, further comprising:
a first voltage transfer line connected to a portion of the plurality of first lines, extending in the second direction, and located between the third transfer line and the first voltage pad; and
a second voltage transfer line connected to a portion of the plurality of second lines, extending in the second direction, and located between the fourth transfer line and the second voltage pad.

11. The display device of claim 10, wherein the first voltage transfer line includes a 1-1-th voltage transfer line on the third insulating layer and covered by the fourth insulating layer and a 1-2-th voltage transfer line on the fourth insulating layer and covered by the fifth insulating layer and the 1-1-th voltage transfer line and the 1-2-th voltage transfer line are connected by a contact hole passing through the fourth insulating layer.

12. The display device of any one of the preceding claims, wherein the first transfer line and each of the plurality of first lines are on different layers of the plurality of insulating layers, and connected through a contact hole defined in an insulating layer between the first transfer line and the plurality of first lines among the plurality of insulating layers.

13. The display device of any one of the preceding claims, wherein minimum distances spaced apart from each other of the plurality of second lines are the same.

14. The display device of claim 1, wherein the first transfer line and the second transfer line are on the same insulating layer among the plurality of insulating layers.

15. The display device of claim 1, wherein the plurality of first lines and the plurality of second lines comprise aluminum (Al) and titanium (Ti).

## Patentansprüche

1. Anzeigevorrichtung, umfassend:
ein Basissubstrat, das einen Anzeigebereich, in dem sich eine Vielzahl von Pixeln befindet, und einen Nicht-Anzeigebereich beinhaltet;
eine Vielzahl von Isolierschichten auf dem Basissubstrat;
ein Kontaktflächenteil, das eine erste Spannungskontaktfläche, die in dem Nicht-Anzeigebereich ist und dazu konfiguriert ist, eine erste Leistungsspannung zu empfangen, eine zweite Spannungskontaktfläche, die dazu konfiguriert ist, eine zweite Leistungsspannung zu empfangen, die sich von der ersten Leistungsspannung unterscheidet, und eine Spannungsmesskontaktfläche beinhaltet;
eine Vielzahl von ersten Leitungen, die elektrisch mit der Vielzahl von Pixeln verbunden ist, den Anzeigebereich überlappt, sich in einer ersten Richtung erstreckt und elektrisch mit der ersten Spannungskontaktfläche verbunden ist;
eine Vielzahl von zweiten Leitungen, die den Anzeigebereich überlappt und sich in der ersten Richtung erstreckt;
eine erste Übertragungsleitung, die elektrisch mit jeder der Vielzahl von ersten Leitungen verbunden ist und sich in einer zweiten Richtung erstreckt, die die erste Richtung kreuzt; und
eine zweite Übertragungsleitung, die sich in der zweiten Richtung erstreckt und den Nicht-Anzeigebereich überlappt,
wobei der Anzeigebereich zwischen der ersten Übertragungsleitung und der ersten Spannungskontaktfläche liegt,
wobei der Anzeigebereich zwischen der zweiten Übertragungsleitung und der zweiten Spannungskontaktfläche liegt,
wobei die Vielzahl von zweiten Leitungen mindestens eine 2-1-te Leitung und mindestens eine 2-2-te Leitung beinhaltet,
wobei die 2-1-te Leitung elektrisch mit dem Spannungsmesskontaktfläche verbunden ist und elektrisch mit der ersten Übertragungsleitung verbunden ist,
wobei die 2-2-te Leitung elektrisch mit der zweiten Spannungskontaktfläche verbunden ist und elektrisch mit der zweiten Übertragungsleitung verbunden ist.

2. Anzeigevorrichtung nach Anspruch 1, wobei jedes der Vielzahl von Pixeln Folgendes beinhaltet:
eine Pixelschaltung, die auf dem Basissubstrat ist und einen Transistor beinhaltet; und
ein lichtemittierendes Element, das elektrisch mit der Pixelschaltung verbunden ist,
wobei die Vielzahl von Isolierschichten eine organische Isolierschicht beinhaltet, die die Vielzahl von ersten Leitungen, die Vielzahl von zweiten Leitungen und die Pixelschaltung abdeckt, und das lichtemittierende Element auf der organischen Isolierschicht liegt.

3. Anzeigevorrichtung nach Anspruch 2, wobei der Transistor Folgendes beinhaltet:
einen Siliziumtransistor, der ein Siliziumhalbleitermuster und ein erstes Gate, das das Siliziumhalbleitermuster überlappt, beinhaltet; und
einen Oxidtransistor, der einen Oxidhalbleitermuster und ein zweites Gate, das das Oxidhalbleitermuster überlappt, beinhaltet,
wobei die Pixelschaltung Folgendes beinhaltet:
eine erste Verbindungselektrode, die elektrisch mit dem Siliziumhalbleitermuster des Siliziumtransistors verbunden ist; und
eine zweite Verbindungselektrode, die mit der ersten Verbindungselektrode verbunden ist,
wobei die Vielzahl von Isolierschichten Folgendes beinhaltet:
eine erste Isolierschicht zwischen dem Siliziumhalbleitermuster und dem ersten Gate;
eine zweite Isolierschicht, die das erste Gate bedeckt und zwischen dem ersten Gate und dem Oxidhalbleitermuster ist;
eine dritte Isolierschicht, die das zweite Gate bedeckt;
eine vierte Isolierschicht, die die erste Verbindungselektrode bedeckt; und
eine fünfte Isolierschicht, die die zweite Verbindungselektrode bedeckt.

4. Anzeigevorrichtung nach Anspruch 2 oder 3, wobei das lichtemittierende Element Folgendes beinhaltet:
eine erste Elektrode auf einer obersten Isolierschicht aus der Vielzahl von Isolierschichten;
eine Emissionsschicht auf der ersten Elektrode, um Licht zu emittieren; und
eine zweite Elektrode auf der Emissionsschicht, um die Emissionsschicht zu bedecken,
wobei die Vielzahl von ersten Leitungen elektrisch mit der ersten Elektrode verbunden ist und die 2-2-te Leitung der Vielzahl von zweiten Leitungen elektrisch mit der zweiten Elektrode verbunden ist.

5. Anzeigevorrichtung nach Anspruch 3 oder 4, wobei jede von der Vielzahl von zweiten Leitungen das gleiche Material wie die zweite Verbindungselektrode beinhaltet.

6. Anzeigevorrichtung nach Anspruch 3, 4 oder 5, ferner umfassend:
eine dritte Übertragungsleitung, die mit der Vielzahl von ersten Leitungen verbunden ist, sich in der zweiten Richtung erstreckt und sich zwischen der ersten Spannungskontaktfläche und dem Anzeigebereich befindet; und
eine vierte Übertragungsleitung, die mit der Vielzahl von zweiten Leitungen verbunden ist, sich in der zweiten Richtung erstreckt und sich zwischen der zweiten Spannungskontaktfläche und dem Anzeigebereich befindet.

7. Anzeigevorrichtung nach einem der Ansprüche 3 bis 6, wobei die Vielzahl von ersten Leitungen und die Vielzahl von zweiten Leitungen auf der vierten Isolierschicht liegen und von der fünften Isolierschicht bedeckt sind.

8. Anzeigevorrichtung nach einem der Ansprüche 3 bis 7, wobei die erste Übertragungsleitung und die zweite Übertragungsleitung auf der dritten Isolierschicht liegen und von der vierten Isolierschicht bedeckt sind.

9. Anzeigevorrichtung nach Anspruch 6, wobei die dritte Übertragungsleitung und die vierte Übertragungsleitung auf der dritten Isolierschicht liegen und von der vierten Isolierschicht bedeckt sind.

10. Anzeigevorrichtung nach Anspruch 6, ferner umfassend:
eine erste Spannungsübertragungsleitung, die mit einem Teil der Vielzahl von ersten Leitungen verbunden ist, sich in der zweiten Richtung erstreckt und sich zwischen der dritten Übertragungsleitung und der ersten Spannungskontaktfläche befindet; und
eine zweite Spannungsübertragungsleitung, die mit einem Teil der Vielzahl von zweiten Leitungen verbunden ist, sich in der zweiten Richtung erstreckt und sich zwischen der vierten Übertragungsleitung und der zweiten Spannungskontaktfläche befindet.

11. Anzeigevorrichtung nach Anspruch 10, wobei die erste Spannungsübertragungsleitung eine 1-1-te Spannungsübertragungsleitung, die auf der dritten Isolierschicht ist und von der vierten Isolierschicht bedeckt ist, und eine 1-2-te Spannungsübertragungsleitung, die auf der vierten Isolierschicht ist und von der fünften Isolierschicht bedeckt ist, beinhaltet und die 1-1-te Spannungsübertragungsleitung und die 1-2-te Spannungsübertragungsleitung durch ein Kontaktloch verbunden sind, das durch die vierte Isolierschicht verläuft.

12. Anzeigevorrichtung nach einem der vorhergehenden Ansprüche, wobei die erste Übertragungsleitung und jede der Vielzahl von ersten Leitungen auf verschiedenen Schichten der Vielzahl von Isolierschichten liegen und durch ein Kontaktloch verbunden sind, das in einer Isolierschicht zwischen der ersten Übertragungsleitung und der Vielzahl von ersten Leitungen aus der Vielzahl von Isolierschichten definiert ist.

13. Anzeigevorrichtung nach einem der vorhergehenden Ansprüche, wobei minimale Abstände, die voneinander beabstandet sind, der Vielzahl von zweiten Leitungen gleich sind.

14. Anzeigevorrichtung nach Anspruch 1, wobei die erste Übertragungsleitung und die zweite Übertragungsleitung auf derselben Isolierschicht aus der Vielzahl von Isolierschichten liegen.

15. Anzeigevorrichtung nach Anspruch 1, wobei die Vielzahl von ersten Leitungen und die Vielzahl von zweiten Leitungen Aluminium (Al) und Titan (Ti) umfassen.

## Revendications

1. Dispositif d'affichage comprenant :
un substrat de base comprenant une zone d'affichage dans laquelle une pluralité de pixels sont situés et une zone de non-affichage ;
une pluralité de couches isolantes sur le substrat de base ;
une partie plot comprenant un premier plot de tension dans la zone de non affichage et configuré pour recevoir une première tension d'alimentation, un second plot de tension configuré pour recevoir une seconde tension d'alimentation différente de la première tension d'alimentation, et un plot de mesure de tension ;
une pluralité de premières lignes électriquement connectées à la pluralité de pixels, chevauchant la zone d'affichage, s'étendant dans une première direction, et électriquement connectées au premier plot de tension ;
une pluralité de secondes lignes chevauchant la zone d'affichage et s'étendant dans la première direction ;
une première ligne de transfert électriquement connectée à chacune de la pluralité de premières lignes et s'étendant dans une seconde direction croisant la première direction ; et
une deuxième ligne de transfert s'étendant dans la seconde direction et chevauchant la zone de non-affichage,
ladite zone d'affichage se trouvant entre la première ligne de transfert et le premier plot de tension, ladite zone d'affichage se trouvant entre la deuxième ligne de transfert et le second plot de tension,
ladite pluralité de secondes lignes comprenant au moins une 2-1-ème ligne et au moins une 2-2-ème ligne,
ladite 2-1-ème ligne étant électriquement connectée au plot de mesure de tension et électriquement connectée à la première ligne de transfert,
ladite 2-2-ème ligne étant électriquement connectée au second plot de tension et électriquement connectée à la deuxième ligne de transfert.

2. Dispositif d'affichage selon la revendication 1, chacun de la pluralité de pixels comprenant : un circuit de pixels sur le substrat de base et comprenant un transistor ; et un élément électroluminescent électriquement connecté au circuit de pixels, ladite pluralité de couches isolantes comprenant une couche isolante organique recouvrant la pluralité de premières lignes, la pluralité de secondes lignes et le circuit de pixels, et ledit élément électroluminescent se trouvant sur la couche isolante organique.

3. Dispositif d'affichage selon la revendication 2, ledit transistor comprenant :
un transistor au silicium comprenant un motif semi-conducteur en silicium et une première grille chevauchant le motif semi-conducteur en silicium ; et
un transistor à oxyde comprenant un motif semi-conducteur d'oxyde et une seconde grille chevauchant le motif semi-conducteur d'oxyde,
ledit circuit de pixels comprenant :
une première électrode de connexion électriquement connectée au motif semi-conducteur en silicium du transistor au silicium ; et
une seconde électrode de connexion connectée à la première électrode de connexion,
ladite pluralité de couches isolantes comprenant :
une première couche isolante entre le motif semi-conducteur en silicium et la première grille ;
une deuxième couche isolante recouvrant la première grille et entre la première grille et le motif semi-conducteur d'oxyde ;
une troisième couche isolante recouvrant la seconde grille ;
une quatrième couche isolante recouvrant la première électrode de connexion ; et
une cinquième couche isolante recouvrant la seconde électrode de connexion.

4. Dispositif d'affichage selon la revendication 2 ou 3, ledit élément électroluminescent comprenant :
une première électrode sur une couche isolante supérieure parmi la pluralité de couches isolantes ;
une couche d'émission sur la première électrode destinée à émettre de la lumière ; et
une seconde électrode sur la couche d'émission destinée à recouvrir la couche d'émission,
ladite pluralité de premières lignes étant électriquement connectées à la première électrode, et ladite 2-2-ème ligne de la pluralité de secondes lignes étant électriquement connectée à la seconde électrode.

5. Dispositif d'affichage selon la revendication 3 ou 4, chacune de la pluralité de secondes lignes comprenant le même matériau que la seconde électrode de connexion.

6. Dispositif d'affichage selon la revendication 3, 4 ou 5, comprenant en outre :
une troisième ligne de transfert connectée à la pluralité de premières lignes, s'étendant dans la seconde direction, et située entre le premier plot de tension et la zone d'affichage ; et
une quatrième ligne de transfert connectée à la pluralité de secondes lignes, s'étendant dans la seconde direction, et située entre le second plot de tension et la zone d'affichage.

7. Dispositif d'affichage selon l'une quelconque des revendications 3 à 6, ladite pluralité de premières lignes et ladite pluralité de secondes lignes se trouvant sur la quatrième couche isolante et étant recouvertes par la cinquième couche isolante.

8. Dispositif d'affichage selon l'une quelconque des revendications 3 à 7, ladite première ligne de transfert et ladite deuxième ligne de transfert se trouvent sur la troisième couche isolante et étant recouvertes par la quatrième couche isolante.

9. Dispositif d'affichage selon la revendication 6, ladite troisième ligne de transfert et ladite quatrième ligne de transfert se trouvant sur la troisième couche isolante et étant recouvertes par la quatrième couche isolante.

10. Dispositif d'affichage selon la revendication 6, comprenant en outre :
une première ligne de transfert de tension connectée à une partie de la pluralité de premières lignes, s'étendant dans la seconde direction, et située entre la troisième ligne de transfert et le premier plot de tension ; et
une deuxième ligne de transfert de tension connectée à une partie de la pluralité de secondes lignes, s'étendant dans la seconde direction, et située entre la quatrième ligne de transfert et le second plot de tension.

11. Dispositif d'affichage selon la revendication 10, ladite première ligne de transfert de tension comprenant une 1-1-ème ligne de transfert de tension sur la troisième couche isolante et recouverte par la quatrième couche isolante et une 1-2-ème ligne de transfert de tension sur la quatrième couche isolante et recouverte par la cinquième couche isolante et ladite 1-1-ème ligne de transfert de tension et ladite 1-2-ème ligne de transfert de tension étant connectées par un trou de contact traversant la quatrième couche isolante.

12. Dispositif d'affichage selon l'une quelconque des revendications précédentes, ladite première ligne de transfert et chacune de la pluralité de premières lignes se trouvant sur différentes couches de la pluralité de couches isolantes, et étant connectées par un trou de contact défini dans une couche isolante entre la première ligne de transfert et la pluralité de premières lignes parmi la pluralité de couches isolantes.

13. Dispositif d'affichage selon l'une quelconque des revendications précédentes, les distances minimales espacées les unes des autres de la pluralité de secondes lignes étant les mêmes.

14. Dispositif d'affichage selon la revendication 1, ladite première ligne de transfert et ladite deuxième ligne de transfert se trouvant sur la même couche isolante parmi la pluralité de couches isolantes.

15. Dispositif d'affichage selon la revendication 1, ladite pluralité de premières lignes et ladite pluralité de secondes lignes comprenant de l'aluminium (Al) et du titane (Ti).
